# FASCICULE DE BREVET EUROPEEN

(11) **EP 3 945 673 B1**
(45) Date de publication et mention de la délivrance du brevet: **09.10.2024**
(21) Numéro de dépôt: 21187089.4
(22) Date de dépôt: 22.07.2021
(51) Int. Cl.: H02M 3/158, H02M 3/156, H03K 5/24, G01R 19/165

(54) **COMPARATEUR DE TENSION**
SPANNUNGSVERGLEICHER
VOLTAGE COMPARATOR

(30) Priorité: 30.07.2020 FR 2008088
(43) Date de publication de la demande: 02.02.2022
(73) Titulaire: STMicroelectronics (Rousset) SAS, 13790 Rousset (FR)
(72) Inventeur: ORTET, Sebastien, 13790 CHATEAUNEUF-LE-ROUGE (FR); DAVINO, Didier, 83910 POURRIERES (FR)
(74) Mandataire: Cabinet Beaumont

(56) Documents cités:
- US-A1- 2009 167 261
- US-A1- 2011 148 377
- US-B2- 6 480 135
- US-B2- 8 692 534
- MITRA S ET AL: "A low-power dual-threshold comparator for neuromorphic systems", RESEARCH IN MICROELECTRONICS AND ELECTRONICS, 2005 PHD JULY, 25, 2005, PISCATAWAY, NJ, USA,IEEE, PISCATAWAY, NJ, USA, vol. 2, 1 July 2005 (2005-07-01), pages 198 - 201, XP010859042, ISBN: 978-0-7803-9345-5, DOI: 10.1109/RME.2005.1542971

## Description

### Domaine technique

La présente description concerne de façon générale les dispositifs électroniques et, plus précisément, les dispositifs comprenant un circuit configuré pour déterminer si une tension est dans une gamme déterminée, par exemple les convertisseurs de tension DC/DC comprenant un tel circuit, de type alimentation à découpage, qui convertissent une tension continue (DC) d'alimentation en une tension continue (DC) de sortie, notamment les convertisseurs de tension DC/DC de type abaisseur ("buck") dans lesquels la tension continue de sortie a une valeur plus faible que celle de la tension continue d'alimentation.

### Technique antérieure

Dans un convertisseur à découpage, une tension d'alimentation du convertisseur est découpée (ou hachée) en commutant des interrupteurs de manière à mettre en oeuvre des phases d'accumulation d'énergie dans un ensemble comprenant un élément inductif et un élément capacitif et des phases de restitution, à une charge connectée en sortie du convertisseur, de l'énergie accumulée dans cet ensemble.

Dans un convertisseur à découpage de type PFM, c'est-à-dire à modulation de fréquence d'impulsion ("Pulse Frequency Modulation"), chaque cycle de fonctionnement du convertisseur comprend une phase d'accumulation d'énergie dans l'ensemble suivie d'une phase de restitution d'énergie à la charge connectée au convertisseur. Pendant la phase d'accumulation d'énergie, le courant traversant l'élément inductif augmente. Pendant la phase de restitution d'énergie, le courant traversant l'élément inductif diminue. Pour chaque cycle de fonctionnement, il est souhaitable que le courant traversant l'élément inductif soit nul au début de la phase d'accumulation d'énergie et à la fin de la phase de restitution d'énergie.

Les convertisseurs à découpage connus, notamment de type PFM, présentent divers inconvénients.

Le document US 2011/0148377 divulgue un convertisseur de tension d'alimentation. L'article de Srinjoy Mitra et Giacomo Indiveri (A low-power dual-threshold comparator for neuromorphic systems) divulgue un comparateur basse tension à double seuils pour des systèmes neuromorphiques. Le document US 2009/0167261 divulgue un dispositif de mesure de courant. Le document US 6480135 divulgue un convertisseur analogique-numérique de type Flash.

### Résumé de l'invention

Un mode de réalisation pallie tout ou partie des inconvénients des dispositifs connus comprenant un circuit configuré pour déterminer le signe d'un courant.

Un mode de réalisation prévoit un dispositif électronique tel que défini dans les revendications.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif électronique comprenant un circuit configuré pour déterminer si une tension est dans une gamme de tensions ;
la figure 2 représente des chronogrammes illustrant le fonctionnement du mode de réalisation de la figure 1 ;
la figure 3 représente des chronogrammes illustrant le fonctionnement du mode de réalisation de la figure 1 ;
la figure 4 représente, de manière très schématique, un exemple de réalisation d'un convertisseur de tension DC/DC ;
la figure 5 représente des chronogrammes illustrant un exemple de fonctionnement du convertisseur de la figure 4 ;
la figure 6 représente d'autres chronogrammes illustrant le fonctionnement souhaité ou théorique et le fonctionnement réel ou pratique du convertisseur de la figure 4 ;
la figure 7 représente un mode de réalisation d'un convertisseur de tension DC/DC comprenant le mode de réalisation de la figure 1 ; et
la figure 8 représente des chronogrammes illustrant un exemple de fonctionnement du mode de réalisation de la figure 7.

### Description des modes de réalisation

Dans la description qui suit divers exemples, modes de réalisation et variantes sont exposés. Nonobstant la façon dont ils sont nommés, seuls font partie de la présente invention, ceux couverts par les revendications.

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

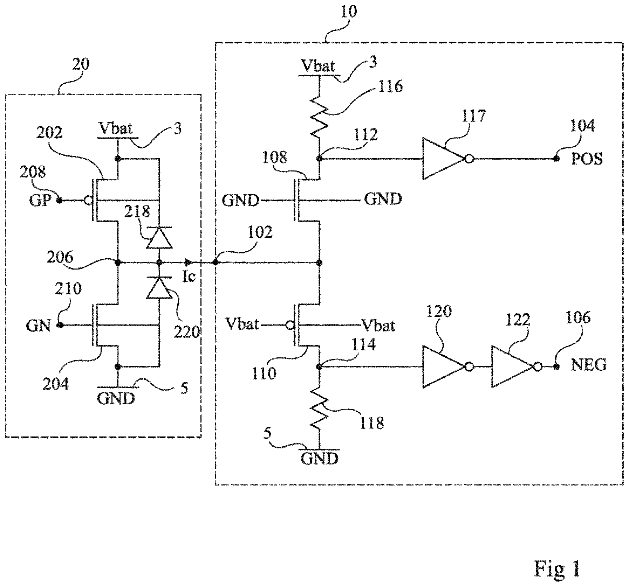

La figure 1 représente un dispositif électronique comprenant un mode de réalisation d'un circuit 10 configuré pour déterminer si une tension d'entrée est dans une gamme de tensions. Autrement dit, le circuit 10 est configuré pour comparer ladite tension d'entrée à des premier et deuxième seuils de tension, différents l'un de l'autre.

Le dispositif comprend un circuit 20, par exemple un étage de puissance. Le circuit 20 est un exemple de circuit configuré pour générer la tension d'entrée du circuit 10. Le circuit 20 comprend deux transistors 202 et 204. Les transistors 202 et 204 sont reliés, de préférence connectés, en série entre un rail 3 d'application d'une tension d'alimentation Vbat et un rail 5 d'application d'une tension de référence, par exemple la masse GND. Autrement dit, une des bornes de conduction, source ou drain, du transistor 202 est reliée, de préférence connectée, au rail 3 et l'autre borne de conduction, drain ou source, est reliée, de préférence connectée, à un noeud central 206. Une des bornes de conduction du transistor 204, source ou drain, est reliée, de préférence connectée, au noeud 206 et l'autre borne de conduction, drain ou source, est reliée, de préférence connectée, au rail 5.

De préférence, le transistor 202 est un transistor à effet de champ de type P, ou PMOS, et le transistor 204 est un transistor à effet de champ de type N, ou NMOS.

Le circuit 20 comprend deux entrées 208 et 210. L'entrée 208 reçoit un signal GP de commande du transistor 202. L'entrée 208 est ainsi reliée, de préférence connectée, à la borne de commande, ou grille, du transistor 202. L'entrée 210 reçoit un signal GN de commande du transistor 204. L'entrée 210 est ainsi reliée, de préférence connectée, à la borne de commande, ou grille, du transistor 204.

Le noeud 206 est relié, de préférence connecté, à un noeud d'entrée 102 du circuit 10. Un courant Ic est fourni, par l'intermédiaire des noeuds 206 et 102, en entrée du circuit 10. De même, une tension VLX, sur le noeud 206, est fournie sur le noeud d'entrée 102 du circuit 10. En fonctionnement, le noeud 206 est par exemple relié à une charge, la charge étant par exemple alimentée par le circuit 20.

Le circuit 20 comprend de plus deux diodes 218 et 220. Les diodes 218 et 220 sont reliées en série entre le rail 3 et le rail 5. Plus précisément, une première borne, anode ou cathode, de la diode 220 est reliée, de préférence connectée, au rail 5 et une deuxième borne, cathode ou anode, de la diode 220 est reliée, de préférence connectée, au noeud 206. Une première borne, anode ou cathode, de la diode 218 est reliée, de préférence connectée, au noeud 206 et une deuxième borne, cathode ou anode, de la diode 218 est reliée, de préférence connectée, au rail 3. Dans l'exemple de la figure 1, les premières bornes des diodes 218 et 220 sont les anodes et les deuxièmes bornes des diodes 218 et 220 sont les cathodes. Le noeud 206 est ainsi relié à l'anode d'une des diodes et à la cathode de l'autre diode.

Autrement dit, chaque diode est reliée, de préférence connectée, en parallèle avec un des transistors 202 et 204. Par exemple, l'anode de la diode 218 est reliée, de préférence connectée, à la source du transistor 202 et la cathode de la diode 218 est reliée, de préférence connectée, au drain du transistor 202. Similairement, l'anode de la diode 220 est reliée, de préférence connectée, à la source du transistor 204 et la cathode de la diode 220 est reliée, de préférence connectée, au drain du transistor 204. Par exemple, la cathode de la diode 218 est aussi reliée, de préférence connectée, au substrat du transistor 202. L'anode de la diode 220 est aussi, par exemple, reliée, de préférence connectée, au substrat du transistor 204. De préférence, les diodes 218 et 220 sont respectivement les diodes intrinsèques des transistors 202 et 204.

Le circuit 10 comprend l'entrée 102 et deux sorties 104 et 106. L'entrée 102 reçoit la tension VLX, que l'on souhaite comparer à la gamme de tensions, et plus précisément, que l'on souhaite comparer aux premier et deuxième seuils de tension. Dans l'exemple de la figure 1, les premier et deuxième seuils sont respectivement la tension positive d'alimentation Vbat du dispositif et une tension de référence GND, de préférence la masse. La sortie 104 fournit un signal POS, de préférence binaire, et la sortie 106 fournit un signal NEG de préférence binaire. Lorsque le circuit 10 détermine que la tension d'entrée est supérieure au premier seuil Vbat de la gamme, le signal NEG prend une première valeur, par exemple une valeur haute. Si la tension d'entrée est inférieure au premier seuil Vbat, la tension NEG prend une deuxième valeur, par exemple une valeur basse. Lorsque le circuit 10 détermine que la tension d'entrée est inférieure au deuxième seuil de la gamme, le signal POS prend une première valeur, par exemple une valeur haute. Si la tension d'entrée est supérieure au deuxième seuil, la tension POS prend une deuxième valeur, par exemple une valeur basse.

Ainsi, si les signaux POS et NEG ont tous deux une valeur basse, cela signifie que la tension d'entrée est comprise entre les premier et deuxième seuils. Si le signal NEG a une valeur haute et le signal POS a une valeur basse, la tension d'entrée a une valeur supérieure au premier seuil. Si le signal NEG a une valeur basse et le signal POS a une valeur haute, la tension d'entrée a une valeur inférieure au deuxième seuil.

Le circuit 10 comprend deux transistors 108 et 110 reliés en série entre les rails 3 et 5. Plus précisément, une des bornes de conduction, source ou drain, du transistor 108 est reliée, de préférence connectée, à un noeud 112. L'autre borne de conduction du transistor 108, drain ou source, est reliée, de préférence connectée, au noeud d'entrée 102. Une des bornes de conduction du transistor 110, source ou drain, est reliée, de préférence connectée, au noeud 102. L'autre borne de conduction du transistor 110, drain ou source, est reliée, de préférence connectée, à un noeud 114.

De préférence, le transistor 110 est un transistor à effet de champ de type P, ou PMOS, et le transistor 108 est un transistor à effet de champ de type N, ou NMOS. De préférence, les transistors 108 et 110 sont reliés, de préférence connectés, au noeud 102, par leurs sources respectives.

Le transistor 108 est commandé par une tension dont la valeur est sensiblement égale, de préférence égale, au deuxième seuil de tension, ici la tension de référence GND. Autrement dit, la borne de commande, ou grille, du transistor 108 est reliée au rail 5 d'application de la tension GND. Le transistor 110 est commandé par une tension dont la valeur est sensiblement égale, de préférence égale, au premier seuil de tension, ici la tension d'alimentation Vbat. Autrement dit, la borne de commande, ou grille, du transistor 110 est reliée au rail 3 d'application de la tension Vbat.

Le noeud 112 est relié au rail 3, de préférence par un élément résistif, ou résistance, 116. Le noeud 112 est aussi relié au noeud de sortie 104, de préférence par un circuit, ou inverseur, 117 configuré pour inverser les signaux binaires. Ainsi, lorsque le circuit 117 reçoit une valeur basse en entrée, il fournit une valeur haute en sortie et inversement.

Le noeud 114 est relié au rail 5, de préférence par un élément résistif, ou résistance, 118. Le noeud 114 est aussi relié au noeud de sortie 106, de préférence par deux circuits, ou inverseurs, 120 et 122 en série configurés pour inverser les signaux binaires.

L'élément résistif 116, le transistor 108, le transistor 110 et l'élément résistif 118 sont ainsi reliés en série dans cet ordre entre le rail 3 et le rail 5.

Les circuits 117, 120 et 122 permettent d'assurer que les signaux POS et NEG soient des signaux binaires ayant des valeurs hautes et basses reconnaissables.

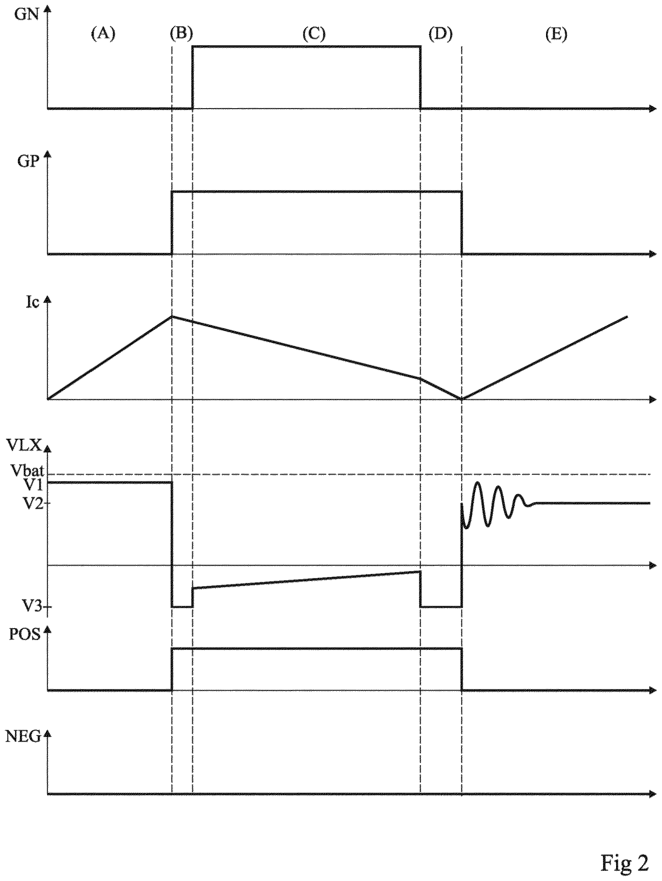

La figure 2 représente des chronogrammes illustrant le fonctionnement du mode de réalisation de la figure 1. Plus précisément, la figure 2 représente le comportement des signaux de commande GN, GP, du courant Ic, de la tension VLX sur le noeud 206, et les signaux POS et NEG, pendant un cycle de fonctionnement du circuit 20 de la figure 1 et pendant une partie (E) d'un cycle suivant. Le cycle de fonctionnement comprend par exemple quatre phases : une phase (A) d'accumulation d'énergie dans un élément inductif non représenté en figure 1 dont une borne est reliée au noeud 102, une phase intermédiaire (B), une phase (C) de restitution d'énergie, et une phase (D) de compensation.

Au cours de la phase (A) d'accumulation d'énergie, le transistor 202 est passant et le transistor 204 est bloqué. Cela correspond, dans le mode de réalisation de la figure 1, au signal de commande GN ayant une valeur basse et au signal de commande GP ayant une valeur basse. La tension VLX a donc une valeur V1 positive, inférieure à la valeur Vbat. Ainsi, durant la phase (A), le courant Ic traversant l'élément inductif non représenté en figure 1 augmente.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (A). Ainsi, la tension sur le noeud 114 a une valeur basse, par exemple sensiblement égale à la tension de référence GND. Le signal NEG, en sortie des inverseurs 120 et 122 a donc une valeur basse.

Similairement, la tension VLX est supérieure à la tension de commande du transistor 108, c'est-à-dire la tension de référence GND, la tension grille-source du transistor 108 est négative. Le transistor 108 reste donc bloqué durant la phase (A). Ainsi, la tension sur le noeud 112 a une valeur haute, par exemple sensiblement égale à la tension Vbat. Le signal POS, en sortie de l'inverseur 117, a donc une valeur basse.

Au cours de la phase (B), les transistors 204 et 202 sont bloqués. Cela correspond, dans le mode de réalisation de la figure 1, au signal de commande GN ayant une valeur basse et au signal de commande GP ayant une valeur haute. La phase (B) est une phase intermédiaire permettant d'assurer que les transistors 208 et 210 ne soient pas passants simultanément. Au cours de la phase (B), le noeud 206 n'est plus alimenté par le rail 3. Le courant Ic diminue donc. Le courant Ic est positif et les transistors 202 et 204 sont bloqués. Le courant Ic traverse donc la diode 220. La tension VLX prend une valeur V3 négative.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (B). Ainsi, la tension sur le noeud 114 est une valeur basse, par exemple sensiblement égale à la tension de référence GND. Le signal NEG, en sortie des inverseurs 120 et 122 a donc une valeur basse.

La tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, a donc une valeur haute.

Les signaux POS et NEG indiquent donc que la tension VLX est inférieure aux deux seuils Vbat et GND. Plus précisément, la valeur basse du signal NEG indique que la tension VLX est inférieure au seuil Vbat est soit dans la gamme comprise entre les valeurs GND et Vbat, soit hors de la gamme et inférieure au seuil GND. La valeur haute du signal POS indique que la tension VLX est inférieure à la valeur de seuil GND, et est donc hors de la gamme comprise entre les valeurs GND et Vbat.

Au cours de la phase (C), c'est-à-dire la phase de restitution d'énergie, le transistor 204 est passant et le transistor 202 est bloqué. Cela correspond, dans le mode de réalisation de la figure 1, au signal de commande GN ayant une valeur haute et au signal de commande GP ayant une valeur haute. La tension VLX croît, mais reste négative. Durant la phase (C), le courant Ic diminue, le noeud 206 n'étant plus alimenté par le rail 3.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (C). Ainsi, la tension sur le noeud 114 a une valeur basse, par exemple sensiblement égale à la tension de référence GND. Le signal NEG, en sortie des inverseurs 120 et 122 a donc une valeur basse.

La tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, a donc une valeur haute.

Au cours de la phase (D), le transistor 204 est bloqué et le transistor 202 est bloqué. Cela correspond, dans le mode de réalisation de la figure 1, au signal de commande GN ayant une valeur basse et au signal de commande GP ayant une valeur haute.

Comme en phase (B), le courant Ic est positif et les transistors 202 et 204 sont bloqués. Le courant Ic traverse donc la diode 220. La tension VLX prend une valeur V3 négative.

La tension VLX étant, comme en phase (B), inférieure à la tension de commande du transistor 110, c'est-à-dire la tension d'alimentation Vbat, la tension grille-source du transistor 110 est positive. Le transistor 110 reste donc bloqué durant la phase (B). Ainsi, la tension sur le noeud 114 a une valeur basse, par exemple sensiblement égale à la tension de référence GND. Le signal NEG, en sortie des inverseurs 120 et 122 a donc une valeur basse.

Comme en phase (B), la tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, a donc une valeur haute.

Durant la phase (D), le courant Ic continue de diminuer. La phase (D) se termine lorsque le courant Ic atteint la valeur zéro.

La phase (D) est par exemple suivie d'une phase (E) correspondant par exemple à la phase (A) d'un cycle de fonctionnement suivant ou à une phase à l'arrêt.

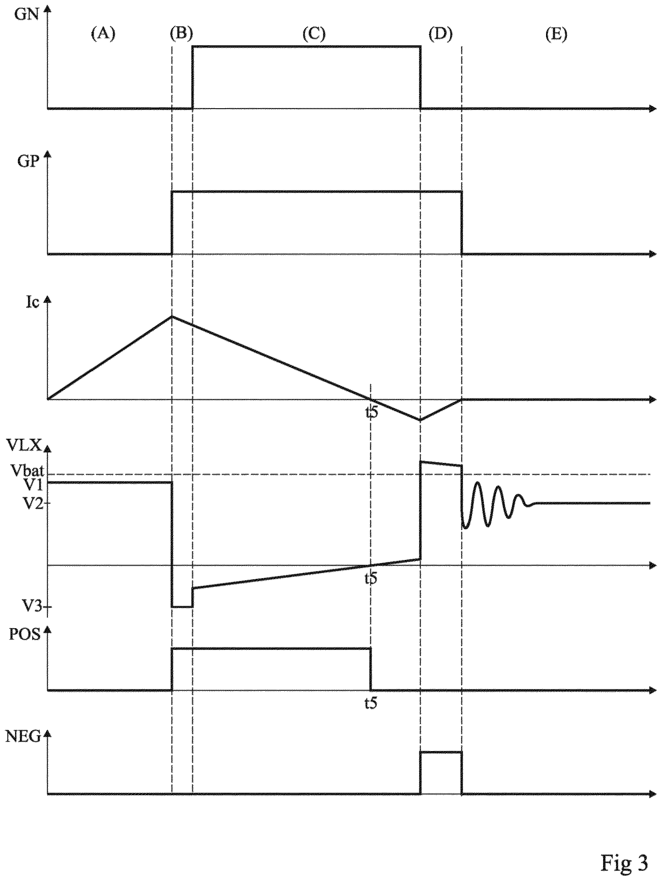

La figure 3 représente des chronogrammes illustrant le fonctionnement du mode de réalisation de la figure 1. Plus précisément, la figure 3 représente le comportement des signaux de commande GN, GP, du courant Ic, de la tension VLX sur le noeud 206, et les signaux POS et NEG, pendant un cycle de fonctionnement du circuit 20 de la figure 1. Le cycle de fonctionnement comprend, comme en figure 2, quatre phases : une phase (A) d'accumulation d'énergie dans l'élément inductif, une phase intermédiaire (B), une phase (C) de restitution d'énergie, et une phase (D) de compensation.

Les phases (A) et (B) sont identiques aux phases (A) et (B) de la figure 2. Elles ne seront donc pas décrites de nouveau.

Au cours de la phase (C) de restitution d'énergie, le transistor 204 est passant et le transistor 202 est bloqué. Cela correspond, dans le mode de réalisation de la figure 1, au signal de commande GN ayant une valeur haute et au signal de commande GP ayant une valeur haute.

La tension VLX croît au cours de la phase (C). A un instant tz de la phase (C), la tension VLX atteint la valeur zéro, puis continue à croitre. Le courant Ic décroit durant la phase (C). A l'instant tz, le courant Ic atteint la valeur zéro. Durant la phase (C), le courant Ic est ainsi positif avant l'instant tz et négatif après l'instant tz et la tension VLX est positive avant l'instant tz, et négatif après l'instant tz.

Durant la phase (C), la tension VLX est inférieure au premier seuil de tension Vbat. Ainsi, le signal NEG maintient la valeur basse. De plus, la tension VLX est inférieure au deuxième seuil de tension GND avant l'instant tz, et supérieure au deuxième seuil après l'instant tz. Ainsi, durant la phase (C), le signal POS prend la valeur haute avant l'instant tz et la valeur basse après l'instant tz.

Au cours de la phase (D), le transistor 204 est bloqué et le transistor 202 est bloqué. Cela correspond, dans le mode de réalisation de la figure 1, au signal de commande GN ayant une valeur basse et au signal de commande GP ayant une valeur haute.

Les transistors 202 et 204 étant bloqués, et le courant Ic étant négatif, la diode 218 devient active. La tension VLX devient donc supérieure à la tension Vbat, par exemple sensiblement égale à la tension Vbat plus la tension de seuil de la diode 218. Ainsi, le courant Ic augmente jusqu'à atteindre zéro. Lorsque le courant atteint la valeur zéro, la phase (D) est terminée.

La tension VLX étant supérieure à la tension de commande du transistor 110, c'est-à-dire la tension d'alimentation Vbat, le signal NEG a une valeur haute. De plus, la tension VLX est supérieure à la tension de commande du transistor 108, c'est-à-dire la tension de référence GND, le signal POS a une valeur basse.

La phase (D) est suivie d'une phase (E), dans laquelle le dispositif se comporte similairement à son comportement dans la phase (A). A titre de variante, la phase (E) correspond à une phase à l'arrêt.

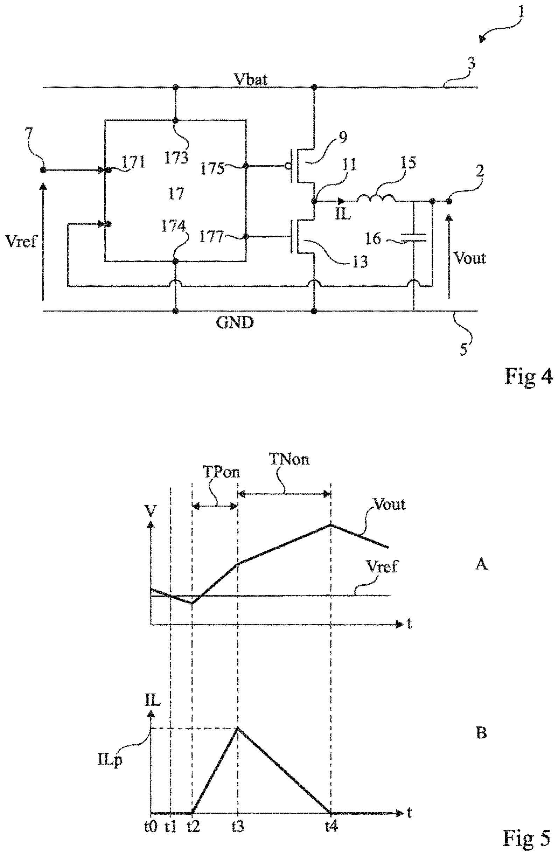

La figure 4 représente de manière très schématique un exemple de réalisation d'un convertisseur de tension DC/DC. Dans cet exemple, le convertisseur 1 est un convertisseur DC/DC, de type alimentation à découpage, qui convertit une tension continue (DC) d'alimentation en une tension continue (DC) de sortie.

Le convertisseur 1 est configuré pour fournir une tension continue de sortie Vout. Le convertisseur comprend un noeud de sortie 2, sur lequel est disponible la tension Vout.

Le convertisseur 1 est alimenté par une tension continue d'alimentation Vbat. Le convertisseur 1 est alors connecté entre un premier rail conducteur, ou noeud, 3 mis à la tension Vbat, et un deuxième rail conducteur, ou noeud, 5 mis au potentiel de référence GND.

Le convertisseur 1 est configuré pour fournir la tension Vout à une valeur égale à une valeur de consigne. Pour cela, le convertisseur 1 reçoit, sur un noeud d'entrée 7, une tension continue de consigne Vref référencée par rapport au potentiel GND, dont la valeur est représentative de la valeur de consigne de la tension Vout, de préférence égale à la valeur de consigne de la tension Vout.

Dans cet exemple, les tensions Vout, Vbat et Vref sont positives.

Dans cet exemple, le convertisseur 1 est de type abaisseur ou buck, c'est-à-dire que la valeur de consigne de la tension Vout est inférieure à la valeur de la tension Vbat. Dit autrement, la valeur de la tension Vout est inférieure à celle de la tension Vbat.

Le convertisseur 1 comprend un premier transistor MOS ("métal oxyde semiconductor" - métal oxyde semiconducteur) 9, de préférence un transistor PMOS (transistor MOS à canal P). Alternativement, le transistor 9 peut aussi être un transistor NMOS associé à un système d'amorçage ("bootstrap"). Le transistor MOS 9 est connecté entre le rail 3 et un noeud interne 11. Dit autrement, une première borne de conduction du transistor 9, par exemple sa source, est connectée au rail 3, une deuxième borne de conduction du transistor 9, par exemple son drain, étant connectée au noeud 11.

Le convertisseur 1 comprend en outre un deuxième transistor MOS 13, de préférence un transistor NMOS (transistor MOS à canal N). Le transistor 13 est connecté entre le noeud 11 et le rail 5. Dit autrement, une première borne de conduction du transistor 13, par exemple sa source, est connectée au rail 5, une deuxième borne de conduction du transistor 13, par exemple son drain, étant connectée au noeud 11. A titre de variante, le transistor NMOS 13 peut être remplacé par une diode ou une diode Schottky.

Ainsi, les transistors 9 et 13 sont connectés en série entre les rails 3 et 5, et sont connectés l'un à l'autre au niveau du noeud interne 11.

Le convertisseur 1 comprend un élément inductif ou inductance 15. L'inductance 15 est connectée entre le noeud 11 et le noeud 2.

Le convertisseur 1 comprend un circuit de commande 17. Le circuit 17 est configuré pour mettre en oeuvre, ou commander, les cycles de fonctionnement du convertisseur 1, de manière à réguler la tension Vout pour que sa valeur soit égale à la valeur de consigne Vref.

Pour cela, le circuit 17 comprend :
- une borne 171 reliée, de préférence connectée, au noeud 7 ;
- une borne 172 reliée, de préférence connectée, au noeud 2 ;
- une borne 173 reliée, de préférence connectée, au rail 3 ;
- une borne 174 reliée, de préférence connectée, au rail 5 ;
- une borne 175 reliée, de préférence connectée, à une borne de commande, ou grille, du transistor 9 ; et
- une borne 176 reliée, de préférence connectée, à une borne de commande, ou grille, du transistor 13.

Le convertisseur 1 comprend une capacité de sortie 16 connectée entre le noeud 2 et le rail 5. A titre d'exemple, cette capacité est de l'ordre de 2,2 µF à 20 µF, voire plus. Cette capacité de sortie joue le rôle de filtre. Dit autrement, cette capacité de sortie du convertisseur permet de lisser le courant présent sur le noeud 2 et de stocker de l'énergie fournie au noeud 2 par le convertisseur.

En fonctionnement, une charge est connectée entre le noeud 2 et le rail 5 de manière à être alimentée par la tension Vout. Cette charge comprend par exemple une capacité d'entrée entre le noeud 2 et le rail 5.

Dans cet exemple, le convertisseur 1 est configuré pour fonctionner en modulation de fréquence d'impulsion (mode de conduction discontinue). Le circuit 17 est alors configuré pour démarrer un cycle de fonctionnement du convertisseur 1 quand la valeur de la tension Vout est inférieure à la valeur de consigne Vref et que les deux transistors 9 et 13 sont à l'état bloqué. Plus particulièrement, au début de chaque cycle de fonctionnement, le circuit 17 est configuré pour commander la mise à l'état passant du transistor 9, le transistor 13 étant laissé à l'état bloqué. De l'énergie est alors accumulée dans l'inductance 15 et dans la capacité 16, pendant une première durée TPon par exemple constante pour chaque cycle de fonctionnement où le transistor 9 est maintenu à l'état passant par le circuit 17, un courant IL circulant alors dans l'inductance 15. A la fin de la durée TPon, le circuit 17 est configuré pour commander la mise à l'état bloqué du transistor 9 et la mise à l'état passant du transistor 13. De l'énergie est alors restituée par l'inductance 15 et la capacité 16, à la charge connectée en sortie du convertisseur, pendant une deuxième durée TNon par exemple constante pour chaque cycle de fonctionnement où le transistor 13 est maintenu à l'état passant par le circuit 17, le courant IL dans l'inductance diminuant. A la fin de la durée TNon, le circuit 17 est configuré pour commander la mise à l'état bloqué du transistor 13.

La durée TNon est déterminée de sorte que l'instant où le circuit 17 commande la mise à l'état bloqué du transistor 13 corresponde à l'instant où le courant IL circulant à travers l'inductance 15 s'annule. Toutefois, en pratique, comme cela sera décrit plus en détail dans la suite de la description, cela n'est pas toujours le cas, ce qui pose problème.

La figure 5 représente des chronogrammes illustrant un exemple de fonctionnement souhaité du convertisseur 1 de la figure 4.

Un chronogramme A (en haut de la figure 5) illustre l'évolution, en fonction du temps t, de la tension Vout, en volts V, un chronogramme B (en bas de la figure 5) illustrant l'évolution correspondante, en fonction du temps t, du courant IL traversant l'inductance 15.

A un instant t0, les transistors 9 et 13 sont à l'état bloqué, le courant IL est nul, et la valeur de la tension Vout est supérieure à sa valeur de consigne, dans cet exemple la valeur de la tension Vref.

Entre l'instant t0 et un instant postérieur t2, la tension Vout diminue, par exemple du fait que la charge connectée au convertisseur 1 consomme du courant et décharge la capacité de sortie.

A un instant t1 entre les instants t0 et t2, la tension Vout devient inférieure à sa valeur de consigne Vref. Cela est détecté par le circuit 17 du convertisseur 1 qui commande alors la mise à l'état passant du transistor 9. Le transistor 9 devient passant à l'instant t2.

Ainsi, à partir de l'instant t2, l'inductance 15 a une borne connectée au noeud 2 et une borne couplée au rail 3, via le transistor 9. Le courant IL circulant à travers l'inductance 15 augmente.

Il en résulte que, à partir de l'instant t2, du courant IL est fourni au noeud 2, et la capacité 16 entre le noeud 2 et le rail 5 se charge. La tension Vout augmente et redevient supérieure à sa valeur de consigne Vref.

A un instant suivant t3, égal à t2 + TPon, le circuit 17 commande la mise à l'état passant du transistor 13 et la mise à l'état bloqué du transistor 9. A l'instant t3, le courant dans l'inductance a une valeur maximale ILp.

Ainsi, à partir de l'instant t3, l'inductance 15 a une borne connectée au noeud 2 et une borne couplée au rail 5, via le transistor 13. Le courant IL circulant à travers l'inductance 15 diminue.

Bien que le courant IL diminue à partir de l'instant t3, la capacité entre le noeud 2 et le rail 5 continue de se charger et la tension Vout continue d'augmenter si le courant tiré par la charge est inférieur au courant IL fourni au noeud 2.

A un instant t4 suivant, égal à t3 + TNon, le circuit 17 commande la mise à l'état bloqué du transistor 13. On considère ici que le convertisseur 1 fonctionne comme il le devrait, et le courant IL est alors nul à l'instant t4. Toutefois, en pratique, ce n'est pas toujours le cas.

A partir de l'instant t4, le courant IL est nul et la tension Vout diminue, de manière similaire à ce qui se passait à l'instant t0.

Bien que cela ne soit pas représenté ici, quand la valeur de la tension Vout repasse en dessous de sa valeur de consigne Vref à un instant postérieur à l'instant t4, le circuit 17 met en oeuvre un nouveau cycle de fonctionnement tel que décrit en relation avec les instants successifs t2, t3 et t4.

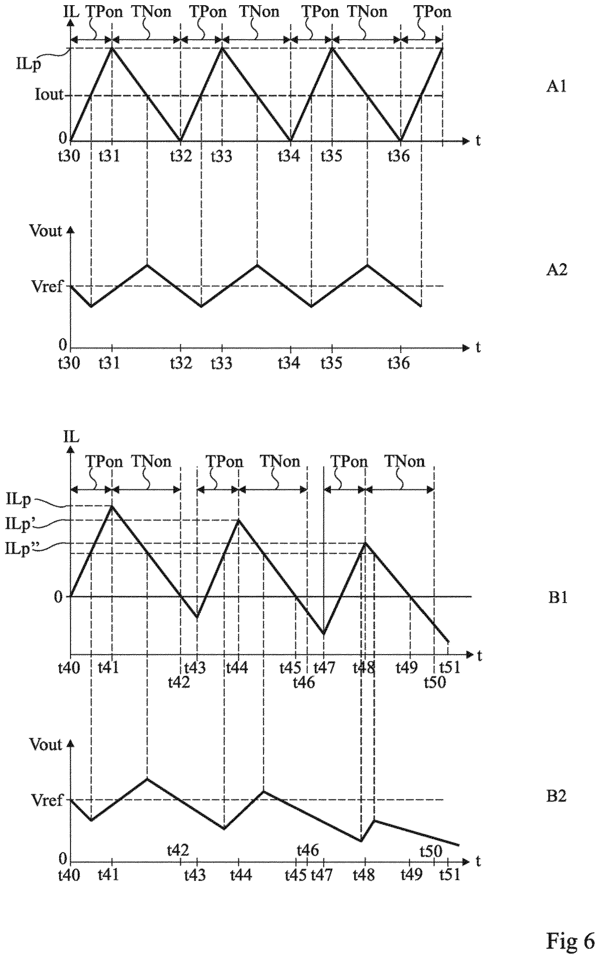

La figure 6 représente d'autres chronogrammes illustrant le fonctionnement du convertisseur 1 de la figure 4. Plus particulièrement, un chronogramme A1 représente un exemple idéal ou théorique de l'évolution du courant IL, un chronogramme A2 représente la tension Vout correspondant aux variations du courant IL du chronogramme A1, un chronogramme B1 représente un exemple de l'évolution réelle du courant IL et un chronogramme B2 représente la tension Vout correspondant aux variations du courant IL du chronogramme B1. Ces chronogrammes illustrent un exemple de fonctionnement où, pour plusieurs cycles de fonctionnement successifs, la tension Vout est inférieure à la tension Vref à la fin de chaque cycle de fonctionnement du convertisseur 1. On considère que le courant pris sur le noeud de sortie est un courant Iout, constant.

A un instant t30 (chronogrammes A1 et A2), la tension Vout est inférieure à la tension Vref. Un cycle de fonctionnement débute avec la commutation à l'état passant du transistor 9. Il en résulte que le courant IL croît jusqu'à un instant suivant t31 égal à t30 + TPon.

A l'instant t31, le courant IL atteint sa valeur maximale ILp. En outre, les transistors 9 et 13 sont commutés respectivement à l'état bloqué et à l'état passant. Il en résulte que le courant décroît jusqu'à un instant suivant t32 égal à t31 + TNon.

Dans cet exemple de fonctionnement idéal, le transistor 13 est commuté à l'état bloqué à l'instant t32, et le courant IL s'annule à cet instant t32.

A l'instant t32, la tension Vout étant inférieure à la tension Vref, le transistor 9 est commuté à l'état passant, ce qui marque le début d'un nouveau cycle de fonctionnement. Le courant IL croît alors jusqu'à un instant suivant t33 égal à t32 + TPon.

A l'instant t33, le courant IL atteint la valeur ILp. En outre, les transistors 9 et 13 sont commutés respectivement à l'état bloqué et à l'état passant. Il en résulte que le courant décroît jusqu'à un instant suivant t34 égal à t33 + TNon.

Dans cet exemple de fonctionnement idéal, le transistor 13 est commuté à l'état bloqué à l'instant t34, et le courant IL s'annule à l'instant t34.

A l'instant t34, la tension Vout étant inférieure à la tension Vref, le transistor 13 est commuté à l'état passant, ce qui marque le début d'un nouveau cycle de fonctionnement. Le courant IL croît jusqu'à un instant suivant t35 égal à t34 + TPon.

A l'instant t35, le courant IL atteint la valeur ILp. En outre, les transistors 9 et 13 sont commutés respectivement à l'état bloqué et à l'état passant. Il en résulte que le courant décroît jusqu'à un instant suivant t36 égal à t35 + TNon.

Dans cet exemple de fonctionnement idéal, le transistor 13 est commuté à l'état bloqué à l'instant t36, et le courant IL s'annule à l'instant t36.

A l'instant t36, la tension Vout étant inférieure à la tension Vref, un nouveau cycle de fonctionnement débute.

Dans l'exemple de fonctionnement théorique illustré par les chronogrammes A1 et A2, à la fin de chaque cycle de fonctionnement, la commutation du transistor 13 à l'état bloqué intervient au moment où le courant IL s'annule. Ainsi, lorsqu'un cycle de fonctionnement est immédiatement suivi par un nouveau cycle de fonctionnement, dans ce nouveau cycle de fonctionnement, le courant IL croît à partir d'une valeur nulle.

Les chronogrammes B1 et B2 illustrent un exemple correspondant de fonctionnement réel du convertisseur 1. Dans cet exemple de fonctionnement réel, on considère le cas pratique où le transistor 13 n'est pas immédiatement commuté à l'état bloqué à la fin de la durée TNon qui s'est écoulée depuis sa dernière commutation à l'état passant.

A un instant t40 (figures 6B1 et 6B2), la tension Vout étant inférieure à la tension Vref, un cycle de fonctionnement débute avec la commutation à l'état passant du transistor 9. Il en résulte que le courant IL croît jusqu'à un instant suivant t41 égal à t40 + TPon.

A l'instant t41, le courant IL atteint sa valeur maximale ILp. En outre, les transistors 9 et 13 sont commutés respectivement à l'état bloqué et à l'état passant. Il en résulte que le courant décroît jusqu'à un instant suivant t42 égal à t41 + TNon. Le courant s'annule à l'instant t42. Toutefois, la commutation du transistor 13 à l'état bloqué n'est effective qu'à un instant t43 postérieur à l'instant t42. Ainsi, entre les instants t42 et t43, le courant IL est négatif et décroît. Dit autrement, le courant circule dans l'inductance 15 du noeud 11 vers le noeud 2 avant l'instant t42, s'annule à l'instant t42, et circule dans l'inductance 15, du noeud 2 vers le noeud 11 après l'instant t42.

A l'instant t43, la tension Vout étant inférieure la tension Vref, le transistor 9 est commuté à l'état passant à l'instant t43, ce qui marque le début d'un nouveau cycle de fonctionnement. Le courant IL croît alors jusqu'à un instant suivant t44 égal à t43 + TPon.

A l'instant t44, le courant IL atteint une valeur ILp', inférieure à la valeur maximale ILp du fait que la durée TPon est constante à chaque cycle. En outre, les transistors 9 et 13 sont commutés respectivement à l'état bloqué et à l'état passant. Il en résulte que le courant IL décroît jusqu'à un instant suivant t46 égal à t44 + TNon, le courant IL s'annulant à un instant t45 compris entre les instants t44 et t46. En outre, la commutation du transistor 13 à l'état bloqué n'est effective qu'à un instant t47 postérieur à l'instant t46. Ainsi, entre les instants t45 et t47, le courant IL est négatif et décroît jusqu'à une valeur plus faible (ou plus grande en valeur absolue) que celle atteinte à l'instant t43.

A l'instant t47, la tension Vout étant inférieure la tension Vref, le transistor 9 est commuté à l'état passant à l'instant t47, ce qui marque le début d'un nouveau cycle de fonctionnement. Le courant IL croît alors jusqu'à un instant suivant t48 égal à t47 + TPon.

A l'instant t48, le courant IL atteint une valeur ILp'', inférieure à la valeur ILp'. En outre, les transistors 9 et 13 sont commutés respectivement à l'état bloqué et à l'état passant. Il en résulte que le courant IL décroît jusqu'à un instant suivant t50 égal à t48 + TNon, le courant IL s'annulant à un instant t49 compris entre les instants t48 et t50. En outre, la commutation du transistor 13 à l'état bloqué n'est effective qu'à un instant t51 postérieur à l'instant t50. Ainsi, entre les instants t49 et t51, le courant IL est négatif et décroît jusqu'à une valeur plus faible (ou plus grande en valeur absolue) que celle atteinte à l'instant t47.

Du fait qu'à chaque cycle de fonctionnement illustré par les chronogrammes B1 et B2, la valeur maximale atteinte par le courant IL (instants t41, t44 et t48) est de plus en plus faible, le convertisseur 1 ne fournit pas assez d'énergie au noeud 2 pour réguler la tension Vout à sa valeur Vref, la tension Vout étant par exemple de plus en plus faible, ce qui pose problème. En outre, à chaque cycle de fonctionnement illustré par les chronogrammes B1 et B2, la valeur négative atteinte par le courant IL (instants t43, t47 et t51) est de plus en plus faible (ou de plus en plus élevée en valeur absolue), d'où il résulte que le convertisseur 1 prélève de plus en plus d'énergie sur le noeud 2, ce qui n'est pas souhaitable. En effet, la valeur du courant fourni à la charge, et en particulier la valeur du pic de courant, décroit d'un cycle à l'autre, ce qui a un impact négatif sur l'alimentation de la charge. De plus, en théorie, la valeur maximale du courant IL pourrait décroître à l'infini, mais, en pratique, le transistor 13 peut, dans certains cas, être détruit, ou endommagé, avant cela par des valeurs négatives du courant IL que le transistor 13 n'est pas en mesure de faire circuler entre ses bornes de conduction.

On a décrit en relation avec les chronogrammes B1 et B2 de la figure 6 un exemple pratique de fonctionnement dans lequel la commutation à l'état bloqué du transistor 13 intervient après l'annulation du courant IL.

Dans un autre exemple pratique de fonctionnement non illustré, à chaque cycle de fonctionnement d'une pluralité de cycles successifs mis en oeuvre immédiatement les uns à la suite des autres, le transistor 13 est commuté à l'état bloqué alors que le courant IL n'est pas nul et est encore positif. Dans ce cas, à chacun des cycles de fonctionnement, le courant IL croît à partir d'une valeur de plus en plus élevée, d'où il résulte que le courant IL atteint une valeur maximale de plus en plus élevée, et que le cycle de fonctionnement se termine avec une valeur non nulle et positive du courant IL de plus en plus élevée. Ce fonctionnement est moins gênant que celui décrit en relation avec les chronogrammes B1 et B2 car, après plusieurs cycles de fonctionnement, la tension Vout aura retrouvé sa valeur de consigne Vref. Ainsi, le cycle de fonctionnement suivant ne sera pas immédiatement mis en oeuvre ce qui laissera le temps au courant IL de s'annuler.

Les deux cas, c'est-à-dire le cas décrit en relation avec les chronogrammes B1 et B2 de la figure 3 et l'autre cas pratique décrit ci-dessus, sont généralement au moins en partie causés par des imperfections au niveau des composants, en particulier des comparateurs, notamment par des temps de fonctionnement (temps de réaction ou de propagation), de comparateurs et par des décalages au niveau des comparateurs. Autrement dit, au lieu de comparer des signaux d'entrées S1 et S2, un comparateur compare les signaux S1 et S2+A, A étant le décalage du comparateur.

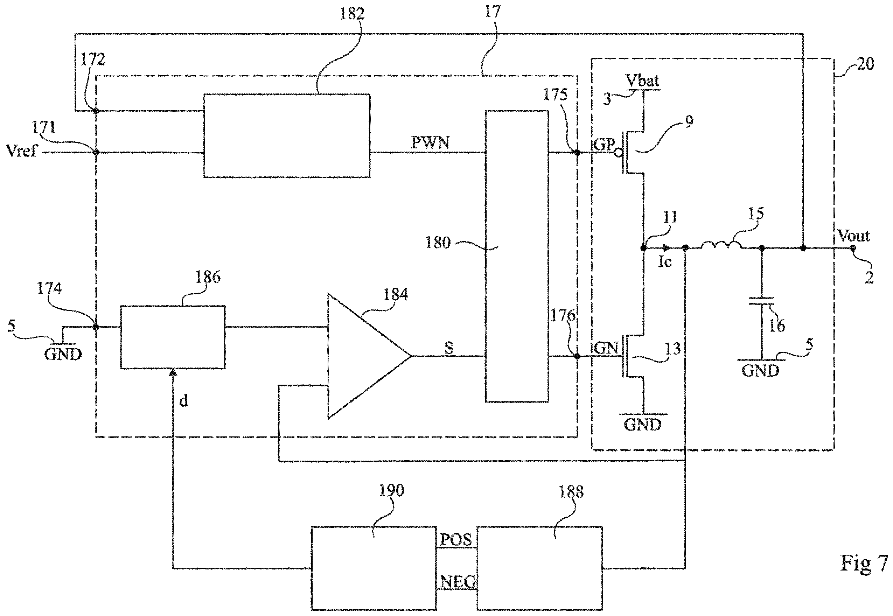

La figure 7 représente un exemple d'application du mode de réalisation du circuit 10 de la figure 1, dans un convertisseur de tension DC/DC. Le convertisseur de la figure 7 comprend les éléments décrits en relation avec la figure 4, le circuit 17 étant plus détaillé.

Le convertisseur comprend les transistors 9 et 13, l'inductance 15 et la capacité 16, décrits en relation avec la figure 4.

Les transistors 9 et 13 sont, comme les transistors 202 et 204 de la figure 1, reliés, de préférence connectés, en série entre le rail 3 d'application d'une tension d'alimentation Vbat et le rail 5 d'application d'une tension de référence, par exemple la masse GND. Autrement dit, une des bornes de conduction, source ou drain, du transistor 9 est reliée, de préférence connectée, au rail 3 et l'autre borne de conduction, drain ou source, est reliée, de préférence connectée, au noeud central 11. Une des bornes de conduction du transistor 13, source ou drain, est reliée, de préférence connectée, au noeud 11 et l'autre borne de conduction, drain ou source, est reliée, de préférence connectée, au rail 5.

De préférence, le transistor 9 est un transistor est à effet de champ de type P, ou PMOS, et le transistor 13 est un transistor à effet de champ de type N, ou NMOS.

Chacun des transistors 9 et 13 comprend une diode intrinsèque non représenté.

Les diodes intrinsèques non représentées sont, comme les diodes 218 et 220 de la figure 1, reliées en série entre le rail 3 et le rail 5. Plus précisément, une première borne, anode ou cathode, de la diode intrinsèque du transistor 13 est reliée, de préférence connectée, au rail 5 et une deuxième borne, cathode ou anode, de ladite diode est reliée, de préférence connectée, au noeud 11. Une première borne, anode ou cathode, de la diode intrinsèque du transistor 9 est reliée, de préférence connectée, au noeud 11 et une deuxième borne, cathode ou anode, de ladite diode est reliée, de préférence connectée, au rail 3. Dans l'exemple de la figure 1, les premières bornes des diodes intrinsèques sont les anodes et les deuxièmes bornes des diodes intrinsèques sont les cathodes. Le noeud 11 est ainsi relié à l'anode d'une des diodes et à la cathode de l'autre diode.

Le convertisseur comprend un circuit 180 de génération des signaux de commande GP, GN, un circuit 182 de fourniture d'un signal PWN déterminant les durées TPon et TNon, un circuit 184 configuré pour déterminer les instants de début de chaque cycle de fonctionnement et un circuit 186 générant une tension variable.

Le circuit 180 comprend des première et deuxième sorties 180a et 180b, respectivement reliées, de préférence connectées, aux sorties 175 et 176 du circuit 17. Le circuit 180 génère, sur la première sortie 180a, le signal GP de commande du transistor 9, et sur la deuxième sortie 180b le signal GN de commande du transistor 13.

Le circuit 180 comprend une entrée 180c reliée, de préférence connectée, à une sortie du circuit 182. Le circuit 182 fournit sur cette sortie le signal PWN déterminant les durées TPon et TNon, et déterminant ainsi les durées des phases d'accumulation d'énergie et de restitution d'énergie.

Le circuit 182 comprend deux entrées 182a et 182b, respectivement reliées, de préférence connectées, aux entrées 171 et 172 du circuit 17. Le circuit 182 génère donc le signal PWN selon la valeur de la tension Vout, reçue sur l'entrée 172, et la tension de consigne Vref, reçue sur l'entrée 171, et plus précisément, selon la différence entre ces valeurs. Ainsi, si la tension Vout est inférieure à la tension Vref, la durée TPon est augmentée et la durée TNon diminuée. Si la tension Vout est supérieure à la tension Vref, la durée TNon est augmentée et la durée TPon est diminuée.

Le convertisseur comprend le circuit 184 configuré pour déterminer les instants de début de chaque cycle de fonctionnement. Plus précisément, le circuit 184 est configuré pour déterminer l'instant auquel le courant Ic atteint la valeur zéro, c'est-à-dire la fin d'un cycle de fonctionnement. En pratique, cela correspond à la détection d'un croisement de la tension VLX avec la valeur zéro. Le circuit 184 comprend une sortie reliée, de préférence connectée, au circuit 180 de manière à fournir cette information par un signal S prenant une valeur haute lorsque le courant Ic atteint la valeur zéro.

Le circuit 184 est par exemple un circuit de détection de croisement de zéro ("Zero Crossing Detect" en anglais, ou ZCD). Le circuit 184 comprend un comparateur.

Le comparateur du circuit 184 est sujet aux défauts évoqués en relation avec la figure 6B. Plus précisément, le retard de propagation et le décalage des tensions d'entrée dudit comparateur entraînent des défauts de comparaison, comme décrit en relation avec la figure 6B.

Le circuit 184 est relié en entrée au rail 5, fournissant la tension de référence GND, et au noeud 11, fournissant la tension VLX.

Le circuit 184 est relié au rail 5 par le circuit 186 configuré pour modifier la valeur à laquelle la tension VLX est comparée, de manière à compenser le retard de propagation et le décalage du comparateur du circuit 184. Par exemple, le circuit 186 est une source variable de tension. Ainsi, la tension en sortie du circuit 186, c'est-à-dire la tension d'entrée du circuit 184 qui est comparée avec la tension VLX, peut être différente de zéro. Le circuit 184 ne compare pas la tension VLX avec la valeur zéro mais avec la valeur de sortie du circuit 186. La valeur de sortie du circuit 186 est par exemple modifiée à chaque cycle de fonctionnement.

De manière à déterminer si le circuit 186 doit modifier sa valeur de sortie, le circuit 186 reçoit un signal d. Le signal d est généré par un ensemble de circuits comprenant un circuit 10 et un circuit 190. Le circuit 10 est donc relié, de préférence connecté, en entrée au noeud 11. Le circuit 10 comprend deux sorties sur lesquelles sont générés les signaux POS et NEG.

Le circuit 190 est relié, de préférence connecté, en entrée, aux sorties du circuit 10 et reçoit donc en entrée les signaux POS et NEG. Le circuit 190 détermine le signe du courant Ic durant la phase (D) et génère le signal d commandant la modification de la valeur de sortie du circuit 186. La modification de tension du circuit 186 est donc dépendante du signe du courant Ic durant la phase (D) et de préférence indépendante du signe du courant durant les autres phases.

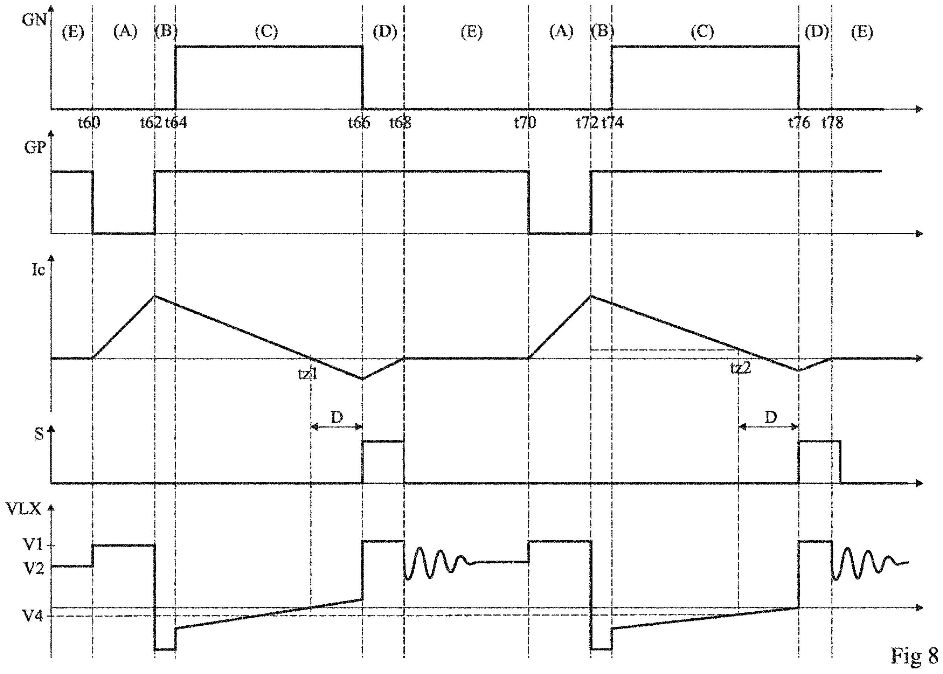

La figure 8 représente des chronogrammes illustrant un exemple de fonctionnement du mode de réalisation de la figure 7. La figure 8 représente deux cycles de fonctionnement du convertisseur, séparés l'uns de l'autre par une phase d'arrêt.

Au cours d'une première phase (E) d'arrêt, les transistors 9 et 13 sont bloqués. Cela correspond à des signaux GN et GP ayant respectivement une valeur basse et une valeur haute. Durant cette phase, le courant Ic est nul et la tension VLX a une valeur sensiblement égale à une tension V2, positive et inférieure à la tension Vbat. De plus, le signal S, de préférence binaire, a par exemple une valeur basse.

A un instant t60, une phase (A) d'un cycle de fonctionnement commence. L'instant t60 correspond donc à la fin d'une phase (E) et au début d'une phase (A).

A l'instant t60, le transistor 9 devient passant. Autrement dit, la valeur du signal de commande GP prend l'autre valeur binaire, ici la valeur basse. Le noeud 11 est donc alimenté par le rail 3. Ainsi, la tension sur le noeud prend la valeur V1, faiblement inférieure à la valeur Vbat mais supérieure à la valeur V2, et le courant Ic augmente.

A un instant t62, la phase (A) se termine et la phase (B) commence. La durée de la phase (A) correspond à la durée TPon.

Comme dans le cas des phases (B) des figures 2 et 3, le transistor 9 est bloqué et le transistor 13 est bloqué. Cela correspond, dans le mode de réalisation de la figure 7, au signal de commande GN ayant une valeur basse et au signal de commande GP ayant une valeur haute. La phase (B) est une phase intermédiaire permettant d'assurer que les transistors 9 et 13 ne soient pas passant simultanément. Au cours de la phase (B), le noeud 11 n'est plus alimenté par le rail 3. Le courant Ic diminue donc.

Le courant Ic est positif et les transistors 202 et 204 sont bloqués. Le courant Ic traverse donc la diode 220. La tension VLX prend une valeur V3 négative.

Durant la phase (B), comme décrit en relation avec les figures 2 et 3, le signal POS prend une valeur haute. Cependant, le circuit 190 ne prend pas en compte les signaux POS et NEG durant la phase (B).

A un instant t62, la phase (B) se termine et la phase (C) commence. Le transistor 13 est passant et le transistor 9 est bloqué. Cela correspond, dans le mode de réalisation de la figure 7, au signal de commande GN ayant une valeur haute et au signal de commande GP ayant une valeur haute. La tension VLX croît et le courant Ic traversant l'inductance 15 diminue, le noeud 11 n'étant plus alimenté par le rail 3.

A un instant tz1 de la phase (C), c'est-à-dire après la durée TNon, le courant Ic et la tension VLX atteignent la valeur zéro. Cependant, le circuit 184 a un retard de propagation d'une valeur D. Ainsi, la sortie S du circuit 184 ne prend une valeur haute, indiquant le croisement du courant Ic avec la valeur zéro, qu'à un instant t66 séparé de l'instant tz1 par la durée D. Entre l'instant tz1 et l'instant t66, le courant Ic devient négatif.

A l'instant t66, le circuit 180 est informé, par le front montant du signal S, que le courant Ic a atteint la valeur zéro. La phase (C) est ainsi finie et la phase (D) commence.

Au cours de la phase (D), les transistors 9 et 13 sont bloqués. Cela correspond, dans le mode de réalisation de la figure 7, au signal de commande GN ayant une valeur basse et au signal de commande GP ayant une valeur haute.

Les transistors 9 et 13 étant bloqués, et le courant Ic étant négatif, la diode intrinsèque du transistor 9 devient active. La tension VLX devient donc supérieure à la tension Vbat, par exemple sensiblement égale à la tension Vbat plus la tension de seuil de la diode. Ainsi, le courant Ic augmente jusqu'à atteindre zéro à un instant t68. Lorsque le courant atteint la valeur zéro, la diode n'est plus passante et la phase (D) est terminée.

A l'instant t68, une phase (E), telle que décrite précédemment, commence. La tension VLX reprend la valeur V2.

Cette phase (E) est suivie d'un second cycle de fonctionnement comprenant une phase (A) entre des instants t70 et t72, une phase (B) entre l'instant t72 et un instant t74, une phase (C) entre l'instant t74 et un instant t76, et une phase (D) entre l'instant t76 et un instant t78.

Le second cycle de fonctionnement diffère du premier cycle en ce que, avant la phase (C), par exemple pendant la phase (A), le circuit 190 fournit un signal d au circuit 186 de manière à modifier la valeur du signal de sortie du circuit 186. Dans le cas du deuxième cycle de fonctionnement, la valeur de la sortie du circuit 186 est modifiée de manière à être égale à une valeur V4 inférieure à la valeur de la tension de référence, ici la masse.

Ainsi, le circuit 184 compare la tension VLX à la valeur V4. La valeur V4 est ici atteinte, à un instant tz2, plus tôt que la valeur zéro est atteinte. La phase (C) se termine la durée D après l'instant tz2. La valeur négative atteinte par le courant Ic à la fin de la phase (C) est plus proche de zéro que la valeur atteinte par le courant Ic à la fin de la phase (C) précédente.

Un avantage des modes de réalisation décrits est qu'il est possible de comparer une tension à deux seuils par un circuit simple.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique comprenant :
- un premier circuit (20) comprenant des premier (202, 9) et deuxième (204, 13) transistors reliés en série entre un noeud (3) d'application d'une tension d'alimentation (Vbat) et un noeud (5) d'application d'une tension de référence (GND), les premier et deuxième transistors étant reliés l'un à l'autre par un premier noeud (206, 11) ; et
- un deuxième circuit (10), configuré pour comparer une première tension (VLX) sur le premier noeud à des premier (Vbat) et deuxième (GND) seuils de tension,
dans lequel le deuxième circuit comprend des troisième (108) et quatrième (110) transistors reliés en série entre des deuxième (112) et troisième (114) noeuds, les troisième et quatrième transistors étant reliés l'un à l'autre par un quatrième noeud (102) relié au premier noeud, et dans lequel le deuxième noeud (112) est relié au noeud d'application (3) de la tension d'alimentation (Vbat) par un premier élément résistif (116), et le troisième noeud (114) est relié au noeud d'application (5) de la tension de référence (GND) par un deuxième élément résistif (118), la borne de commande du troisième transistor (108) étant reliée à un noeud d'application du deuxième seuil de tension, et la borne de commande du quatrième transistor (110) étant reliée à un noeud d'application du premier seuil de tension, le deuxième circuit (10) comprenant :
- un premier noeud de sortie (106), configuré pour fournir un signal (NEG) prenant une première valeur lorsque la première tension (VLX) est supérieure au premier seuil de tension (Vbat) et une deuxième valeur lorsque la première tension (VLX) est inférieure au premier seuil de tension (Vbat), le premier noeud de sortie (106) étant relié au troisième noeud (114) ; et
- un deuxième noeud de sortie (104), configuré pour fournir un signal (POS) prenant une première valeur lorsque la première tension (VLX) est inférieure au deuxième seuil (GND) de tension et une deuxième valeur lorsque la première tension est supérieure au deuxième seuil de tension, le deuxième noeud de sortie (104) étant relié au deuxième noeud (112) .

2. Procédé de commande d'un dispositif électronique comprenant :
- un premier circuit (20) comprenant des premier (202, 9) et deuxième (204, 13) transistors reliés en série entre un noeud (3) d'application d'une tension d'alimentation (Vbat) et un noeud (5) d'application d'une tension de référence (GND), les premier et deuxième transistors étant reliés l'un à l'autre par un premier noeud (206, 11) ; et
- un deuxième circuit (10),
le deuxième circuit comparant une première tension (VLX) sur le premier noeud à des premier (Vbat) et deuxième (GND) seuils de tension,
dans lequel le deuxième circuit comprend des troisième (108) et quatrième (110) transistors reliés en série entre des deuxième (112) et troisième (114) noeuds, les troisième et quatrième transistors étant reliés l'un à l'autre par un quatrième noeud (102) relié au premier noeud, et dans lequel le deuxième noeud (112) est relié au noeud d'application (3) de la tension d'alimentation (Vbat) par un premier élément résistif (116), et le troisième noeud (114) est relié au noeud d'application (5) de la tension de référence (GND) par un deuxième élément résistif (118), la borne de commande du troisième transistor (108) étant reliée à un noeud d'application du deuxième seuil de tension, et la borne de commande du quatrième transistor (110) étant reliée à un noeud d'application du premier seuil de tension, le deuxième circuit (10) comprenant :
- un premier noeud de sortie (106) fournissant un signal (NEG) prenant une première valeur lorsque la première tension (VLX) est supérieure au premier seuil de tension (Vbat) et une deuxième valeur lorsque la première tension (VLX) est inférieure au premier seuil de tension (Vbat), le premier noeud de sortie (106) étant relié au troisième noeud (114) ; et
- un deuxième noeud de sortie (104) fournissant un signal (POS) prenant une première valeur lorsque la première tension (VLX) est inférieure au deuxième seuil (GND) de tension et une deuxième valeur lorsque la première tension est supérieure au deuxième seuil de tension, le deuxième noeud de sortie (104) étant relié au deuxième noeud (112).

3. Dispositif selon l'une quelconque des revendications 1 ou procédé selon la revendication 2, dans lequel le premier seuil de tension est la tension d'alimentation (Vbat) et le deuxième seuil de tension est la tension de référence (GND).

4. Dispositif selon la revendication 1 ou 3 ou procédé selon la revendication 2 ou 3, dans lequel le premier noeud de sortie (106) est relié au troisième noeud (114) par deux circuits inverseurs (120, 122) et le deuxième noeud de sortie (104) est relié au deuxième noeud (112) par un circuit inverseur (117).

5. Dispositif selon l'une quelconque des revendications 1, 3 ou 4 ou procédé selon l'une quelconque des revendications 2 à 4, dans lequel le premier transistor (202) est connecté en parallèle avec une première diode (218), le deuxième transistor (204) est connecté en parallèle avec une deuxième diode (220), l'anode de la première diode et la cathode de la deuxième diode étant connectées au premier noeud (206).

6. Dispositif selon l'une quelconque des revendications 1 ou 3 à 5 ou procédé selon l'une quelconque des revendications 2 à 5, dans lequel le dispositif est une alimentation à découpage.

7. Dispositif ou procédé selon la revendication 6, dans lequel le dispositif comprend un troisième circuit (184) configuré pour comparer la première tension (VLX) à une deuxième tension, la deuxième tension étant variable et dépendant des signaux sur les premier et deuxième noeud de sortie.

8. Dispositif selon l'une quelconque des revendications 1 ou 3 à 7 ou procédé selon l'une quelconque des revendications 2 à 7, dans lequel le dispositif comprend un quatrième circuit configuré pour commander les premier et deuxième transistors de telle manière que chaque cycle de fonctionnement comprennent successivement :
- une première phase durant laquelle le premier transistor est passant et le deuxième transistor est bloqué ;
- une deuxième phase durant laquelle les premier et deuxième transistors sont bloqués ;
- une troisième phase durant laquelle le premier transistor est bloqué et le deuxième transistor est passant ; et
- une quatrième phase durant laquelle les premier et deuxième transistors sont bloqués.

9. Dispositif ou procédé selon les revendications 7 et 8, dans lequel la variation de la deuxième tension est dépendante des signaux sur les premier et deuxième noeuds de sortie durant la quatrième phase.

## Patentansprüche

1. Elektronische Vorrichtung, die Folgendes aufweist:
- eine erste Schaltung (20) mit einem ersten (202, 9) und einem zweiten (204, 13) Transistor, die zwischen einem Knoten (3) zum Anlegen einer Versorgungsspannung (Vbat) und einem Knoten (5) zum Anlegen einer Referenzspannung (GND) in Reihe geschaltet sind, wobei der erste und der zweite Transistor über einen ersten Knoten (206, 11) miteinander verbunden sind; und
- eine zweite Schaltung (10), die konfiguriert ist zum Vergleichen einer ersten Spannung (VLX) am ersten Knoten mit ersten (Vbat) und zweiten (GND) Spannungsschwellenwerten,
wobei die zweite Schaltung einen dritten (108) und einen vierten (110) Transistor aufweist, die zwischen einem zweiten (112) und einem dritten (114) Knoten in Reihe geschaltet sind, wobei der dritte und der vierte Transistor über einen vierten Knoten (102), der mit dem ersten Knoten verbunden ist, miteinander verbunden sind, und wobei der zweite Knoten (112) über ein erstes Widerstandselement (116) mit dem Knoten (3) zum Anlegen der Versorgungsspannung (Vbat) verbunden ist, und wobei der dritte Knoten (114) mit dem Knoten (5) zum Anlegen der Referenzspannung (GND) über ein zweites Widerstandselement (118) verbunden ist, wobei der Steueranschluss des dritten Transistors (108) mit einem Knoten zum Anlegen des zweiten Spannungsschwellenwerts verbunden ist, und der Steueranschluss des vierten Transistors (110) mit einem Knoten zum Anlegen des ersten Spannungsschwellenwerts verbunden ist, wobei die zweite Schaltung (10) Folgendes aufweist:
- einen ersten Ausgangsknoten (106), der konfiguriert ist zum Liefern eines Signals (NEG), das einen ersten Wert annimmt, wenn die erste Spannung (VLX) höher als der erste Spannungsschwellenwert (Vbat) ist, und einen zweiten Wert annimmt, wenn die erste Spannung (VLX) niedriger als der erste Spannungsschwellenwert (Vbat) ist, wobei der erste Ausgangsknoten (106) mit dem dritten Knoten (114) verbunden ist; und
- einen zweiten Ausgangsknoten (104), der konfiguriert ist zum Liefern eines Signals (POS) liefert, das einen ersten Wert annimmt, wenn die erste Spannung (VLX) niedriger als der zweite Spannungsschwellenwert (GND) ist, und einen zweiten Wert annimmt, wenn die erste Spannung höher als der zweite Spannungsschwellenwert ist, wobei der zweite Ausgangsknoten (104) mit dem zweiten Knoten (112) verbunden ist.

2. Verfahren zum Steuern eines elektronischen Geräts, das Folgendes aufweist:
- eine erste Schaltung (20) mit einem ersten (202, 9) und einem zweiten (204, 13) Transistor, die zwischen einem Knoten (3) zum Anlegen einer Versorgungsspannung (Vbat) und einem Knoten (5) zum Anlegen einer Referenzspannung (GND) in Reihe geschaltet sind, wobei der erste und der zweite Transistor über einen ersten Knoten (206, 11) miteinander verbunden sind; und
- eine zweite Schaltung (10),
wobei die zweite Schaltung konfiguriert ist zum Vergleichen einer ersten Spannung (VLX) am ersten Knoten mit ersten (Vbat) und zweiten (GND) Spannungsschwellenwerten,
wobei die zweite Schaltung einen dritten (108) und einen vierten (110) Transistor aufweist, die zwischen einem zweiten (112) und einem dritten (114) Knoten in Reihe geschaltet sind, wobei der dritte und der vierte Transistor über einen vierten Knoten (102), der mit dem ersten Knoten verbunden ist, miteinander verbunden sind, und wobei der zweite Knoten (112) über ein erstes Widerstandselement (116) mit dem Knoten (3) zum Anlegen der Versorgungsspannung (Vbat) verbunden ist, und wobei der dritte Knoten (114) mit dem Knoten (5) zum Anlegen der Referenzspannung (GND) über ein zweites Widerstandselement (118) verbunden ist, wobei der Steueranschluss des dritten Transistors (108) mit einem Knoten zum Anlegen des zweiten Spannungsschwellenwerts verbunden ist, und der Steueranschluss des vierten Transistors (110) mit einem Knoten zum Anlegen des ersten Spannungsschwellenwerts verbunden ist, wobei die zweite Schaltung (10) Folgendes aufweist:
- einen ersten Ausgangsknoten (106), der ein Signal (NEG) liefert, das einen ersten Wert annimmt, wenn die erste Spannung (VLX) höher als der erste Spannungsschwellenwert (Vbat) ist, und einen zweiten Wert annimmt, wenn die erste Spannung (VLX) niedriger als der erste Spannungsschwellenwert (Vbat) ist, wobei der erste Ausgangsknoten (106) mit dem dritten Knoten (114) verbunden ist; und
- einen zweiten Ausgangsknoten (104), der ein Signal (POS) liefert, das einen ersten Wert annimmt, wenn die erste Spannung (VLX) niedriger als die zweite Spannungsschwelle (GND) ist, und einen zweiten Wert annimmt, wenn die erste Spannung höher als die zweite Spannungsschwelle ist, wobei der zweite Ausgangsknoten (104) mit dem zweiten Knoten (112) verbunden ist.

3. Vorrichtung nach Anspruch 1 oder Verfahren nach Anspruch 2, wobei die erste Spannungsschwelle die Versorgungsspannung (Vbat) und die zweite Spannungsschwelle die Referenzspannung (GND) ist.

4. Vorrichtung nach Anspruch 1 oder 3 oder Verfahren nach Anspruch 2 oder 3, wobei der erste Ausgangsknoten (106) über zwei Inverterschaltungen (120, 122) mit dem zweiten Knoten (114) verbunden ist und der zweite Ausgangsknoten (104) über eine Inverterschaltung (117) mit dem zweiten Knoten (112) verbunden ist.

5. Vorrichtung nach einem der Ansprüche 1, 3 oder 4 oder Verfahren nach einem der Ansprüche 2 bis 4, wobei der erste Transistor (202) parallel zu einer ersten Diode (218) geschaltet ist, der zweite Transistor (204) parallel zu einer zweiten Diode (220) geschaltet ist, wobei die Anode der ersten Diode und die Kathode der zweiten Diode mit dem ersten Knoten (206) verbunden sind.

6. Vorrichtung nach einem der Ansprüche 1 oder 3 bis 5 oder Verfahren nach einem der Ansprüche 2 bis 5, wobei die Vorrichtung ein Schaltnetzteil ist.

7. Vorrichtung oder Verfahren nach Anspruch 6, wobei die Vorrichtung eine dritte Schaltung (184) aufweist, die konfiguriert ist zum Vergleichen einer ersten Spannung (VLX) mit einer zweiten Spannung, wobei die zweite Spannung variabel ist und von den Signalen an den ersten und zweiten Ausgangsknoten abhängt.

8. Vorrichtung nach einem der Ansprüche 1 oder 3 bis 7 oder Verfahren nach einem der Ansprüche 2 bis 7, wobei die Vorrichtung eine vierte Schaltung aufweist, die konfiguriert ist zum Steuern der ersten und zweiten Transistoren so, dass jeder Betriebszyklus aufeinanderfolgend aufweist:
- eine erste Phase, in der der erste Transistor eingeschaltet und der zweite Transistor ausgeschaltet ist;
- eine zweite Phase, in der der erste und der zweite Transistor ausgeschaltet sind;
- eine dritte Phase, in der der erste Transistor ausgeschaltet ist und der zweite Transistor eingeschaltet ist; und
- eine vierte Phase, in der der erste und der zweite Transistor ausgeschaltet sind.

9. Vorrichtung oder Verfahren nach den Ansprüchen 7 und 8, wobei die Änderung der zweiten Spannung von den Signalen an den ersten und zweiten Ausgangsknoten während der vierten Phase abhängt.

## Claims

1. Electronic device comprising:
- a first circuit (20) comprising first (202, 9) and second (204, 13) transistors series-coupled between a node (3) for applying a power supply voltage (Vbat) and a node (5) for applying a reference voltage (GND), the first and second transistors being coupled to each other by a first node (206, 11); and
- a second circuit (10), configured to compare a first voltage (VLX) on the first node with first (Vbat) and second (GND) voltage thresholds,
wherein the second circuit comprises third (108) and fourth (110) transistors series-coupled between second (112) and third (114) nodes, the third and fourth transistors being coupled to each other by a fourth node (102) coupled to the first node, and wherein the second node (112) is coupled to the node (3) for applying the power supply voltage (Vbat) by a first resistive element (116), and the third node (114) is coupled to the node (5) for applying the reference voltage (GND) by a second resistive element (118), the control terminal of the third transistor (108) being coupled to a node for applying the second voltage threshold, and the control terminal of the fourth transistor (110) being coupled to a node for applying the first voltage threshold, the second circuit (10) comprising:
- a first output node (106), configured to supply a signal (NEG) taking a first value when the first voltage (VLX) is higher than the first voltage threshold (Vbat) and a second value when the first voltage (VLX) is lower than the first voltage threshold (Vbat), the first output node (106) being coupled to the third node (114); and
- a second output node (104), configured to supply a signal (POS) taking a first value when the first voltage (VLX) is lower than the second voltage threshold (GND) and a second value when the first voltage is higher than the second voltage threshold, the second output node (104) being coupled to the second node (112).

2. Method for controlling an electronic device comprising:
- a first circuit (20) comprising first (202, 9) and second (204, 13) transistors series-coupled between a node (3) for applying a power supply voltage (Vbat) and a node (5) for applying a reference voltage (GND), the first and second transistors being coupled to each other by a first node (206, 11); and
- a second circuit (10),
the second circuit configured comparing a first voltage (VLX) on the first node to first (Vbat) and second (GND) voltage thresholds,
wherein the second circuit comprises third (108) and fourth (110) transistors series-coupled between second (112) and third (114) nodes, the third and fourth transistors being coupled to each other by a fourth node (102) coupled to the first node, and wherein the second node (112) is coupled to the node (3) for applying the power supply voltage (Vbat) by a first resistive element (116), and the third node (114) is coupled to the node (5) for applying the reference voltage (GND) by a second resistive element (118), the control terminal of the third transistor (108) being coupled to a node for applying the second voltage threshold, and the control terminal of the fourth transistor (110) being coupled to a node for applying the first voltage threshold, the second circuit (10) comprising:
- a first output node (106), supplying a signal (NEG) taking a first value when the first voltage (VLX) is higher than the first voltage threshold (Vbat) and a second value when the first voltage (VLX) is lower than the first voltage threshold (Vbat), the first output node (106) being coupled to the third node (114); and
- a second output node (104), supplying a signal (POS) taking a first value when the first voltage (VLX) is lower than the second voltage threshold (GND) and a second value when the first voltage is higher than the second voltage threshold, the second output node (104) being coupled to the second node (112).

3. Device according to any one of claims 1 or method according to claim 2, wherein the first voltage threshold is the power supply voltage (Vbat) and the second voltage threshold is the reference voltage (GND).

4. Device according to claim 1 or 3 or method according to claim 2 or 3, wherein the first output node (106) is coupled to the second node (114) by two inverter circuits (120, 122) and the second output node (104) is coupled to the second node (112) by an inverter circuit (117).

5. Device according to any one of claims 1, 3 or 4 or method according to any one of claims 2 to 4, wherein the first transistor (202) is connected in parallel with a first diode (218), the second transistor (204) is connected in parallel with a second diode (220), the anode of the first diode and the cathode of the second diode being connected to the first node (206).

6. Device according to any one of claims 1 or 3 to 5 or method according to any one of claims 2 to 5, wherein the device is a switched-mode power supply.

7. Device or method according to claim 6, wherein the device comprises a third circuit (184) configured to compare the first voltage (VLX) with a second voltage, the second voltage being variable and dependent on the signals on the first and second output nodes.

8. Device according to any one of claims 1 or 3 to 7 or method according to any one of claims 2 to 7, wherein the device comprises a fourth circuit configured to control the first and second transistors such that each operating cycle comprises consecutively:
- a first phase during which the first transistor is ON and the second transistor is OFF;
- a second phase during which the first and second transistors are OFF;
- a third phase during which the first transistor is OFF and the second transistor is ON; and
- a fourth phase during which the first and second transistors are OFF.

9. Device or method according to claims 7 and 8, wherein the variation of the second voltage is dependent on the signals on the first and second output nodes during the fourth phase.
